# FASCICULE DE BREVET EUROPEEN

(11) **EP 3 849 769 B1**
(45) Date de publication et mention de la délivrance du brevet: **29.03.2023**
(21) Numéro de dépôt: 19765266.2
(22) Date de dépôt: 11.09.2019
(51) Int. Cl.: B29C 43/02, B29C 33/42, B29C 33/38, H01L 25/16, H01L 27/32, H01L 51/00, H01L 51/44, H01L 51/42, G09F 9/30, B29K 507/04, B29L 31/00

(54) **PROCÉDÉ DE FABRICATION D'UN SUBSTRAT DE COMPOSANT OPTO-ELECTRONIQUE ET DISPOSITIFS ASSOCIÉS**
VERFAHREN ZUR HERSTELLUNG EINES SUBSTRATS EINER OPTOELEKTRONISCHEN KOMPONENTE UND ZUGEHÖRIGE VORRICHTUNGEN
METHOD FOR MANUFACTURING AN OPTO-ELECTRONIC COMPONENT SUBSTRATE AND ASSOCIATED DEVICES

(30) Priorité: 11.09.2018 FR 1858138
(43) Date de publication de la demande: 21.07.2021
(73) Titulaire: Centre national de la recherche scientifique, 75016 Paris (FR); UNIVERSITE PAUL SABATIER TOULOUSE III, 31062 Toulouse Cedex 9 (FR)
(72) Inventeur: LOPES, Manuel, 31810 Venerque (FR); SCHLEGEL, Benoit, 11150 Villepinte (FR); BUSO, David, 31860 Labarthe sur Lèze (FR); ZISSIS, Georges, 31500 Toulouse (FR)
(74) Mandataire: Lavoix
(86) Numéro de dépôt international: PCT/EP2019/074189
(87) Numéro de publication internationale: WO 2020/053253

(56) Documents cités:
- US-A1- 2004 164 674
- US-A1- 2014 267 107
- US-A1- 2017 229 668
- BHARATHAN JAYESH ET AL: "Polymer electroluminescent devices processed by inkjet printing: I. Polymer light-emitting logo", APPLIED PHYSICS LETTERS, A I P PUBLISHING LLC, US, vol. 72, no. 21, 25 mai 1998 (1998-05-25), pages 2660-2662, XP012020277, ISSN: 0003-6951, DOI: 10.1063/1.121090

## Description

La présente invention concerne un procédé de fabrication d'un substrat de composant opto-électronique. L'invention se rapporte également à un procédé de fabrication d'un composant opto-électronique. L'invention concerne aussi un substrat de composant opto-électronique susceptible d'être obtenu par le procédé précité. L'invention se rapporte également à un composant opto-électronique, un ensemble et un appareil de fabrication associés.

La protection de l'environnement et la gestion des ressources naturelles sont devenues des préoccupations de la première importance au niveau national et international. Parmi les différents domaines technologiques énergivores, on peut citer l'éclairage électrique qui représente approximativement 19 % de la production globale de l'électricité mondiale. Une telle consommation d'énergie électrique s'accompagne de l'émission d'environ 1 900 millions de tonnes de gaz à effet de serre.

De ce fait, des technologies alternatives se développent parmi lesquelles la technologie à base d'OLED (« Organic Light-Emitting Diode » signifiant diode électroluminescente organique). Une telle technologie permet en effet d'obtenir une bonne qualité d'éclairage ainsi qu'une faible consommation électrique.

Il est connu de fabriquer les diodes électroluminescentes organiques par dépôt des différentes couches sur un substrat.

US2004164674 A1, par exemple, divulgue un procédé de production d'une diode électroluminescente organique avec une zone lumineuse structurée et un substrat.

Il est souhaitable qu'un tel substrat présente des qualités surfaciques très précises. En particulier, une rugosité maximum de 50 nanomètres (nm) est recommandée. De préférence, une rugosité maximum de 20 nanomètres est souhaitée.

Pour cela, des techniques de dépositions sous vide relativement complexes à mettre en oeuvre sont souvent utilisées. La complexité résulte notamment du fait qu'il convient d'avoir une installation sous vide ainsi que des moyens pour faire croître les différentes couches constituant le substrat.

Il existe donc un besoin pour un procédé de fabrication d'un substrat pour un composant opto-électronique qui soit de mise en oeuvre plus simple.

A cet effet, la présente description propose un procédé de fabrication d'un substrat de composant opto-électronique comportant un empilement de couches, le procédé comportant une étape de préformation d'un substrat comportant une face présentant un motif avec au moins une zone en un premier matériau et une zone en un deuxième matériau, les deux matériaux étant des matériaux polymères thermodurcissables ou thermoplastiques, le premier matériau étant un matériau conducteur électrique et le deuxième matériau étant un matériau isolant électrique, et une étape de moulage par compression de la face du substrat avec une face d'un élément de référence présentant une rugosité de surface inférieure ou égale à 50 nanomètres.

Suivant des modes de réalisations particuliers, le procédé de fabrication comprend une ou plusieurs des caractéristiques suivantes lorsque cela est techniquement possible :
- la face de l'élément de référence présente une rugosité de surface inférieure ou égale à 20 nanomètres.
- le premier matériau est identique au deuxième matériau.
- lors de l'étape de préformation, il est utilisé une technique de fabrication additive.

La présente description porte également sur un procédé de fabrication d'un composant opto-électronique, notamment une diode électroluminescente organique ou une cellule photovoltaïque organique, comportant les étapes du procédé de fabrication d'un substrat, le procédé étant tel que précédemment décrit.

La présente description se rapporte aussi à un substrat obtenu par le procédé de fabrication tel que précédemment décrit.

Il est également décrit un composant opto-électronique, notamment une diode électroluminescente organique ou une cellule photovoltaïque organique, comportant un substrat tel que précédemment décrit.

La présente description propose également un ensemble, notamment panneau d'affichage ou source d'éclairage, comportant une pluralité de composants opto-électroniques tels que précédemment décrits.

La présente description concerne aussi un appareil de fabrication d'un substrat de composant opto-électronique comportant un empilement de couches, l'appareil de fabrication comportant une unité de préformation d'un substrat comportant une face présentant un motif avec au moins une zone en un premier matériau et une zone en un deuxième matériau, les deux matériaux étant des matériaux thermodurcissables ou thermoplastiques, le premier matériau étant un matériau conducteur électrique et le deuxième matériau étant un matériau isolant électrique, et l'appareil de fabrication comportant une unité de moulage par compression de la face du substrat avec une face d'un élément de référence présentant une rugosité de surface inférieure ou égale à 50 nanomètres.

D'autres caractéristiques et avantages de l'invention apparaîtront à la lecture de la description qui suit le mode de réalisation de l'invention, donné à titre d'exemple uniquement en référence aux dessins qui sont :
- figure 1, une représentation schématique d'un appareil de fabrication ;
- figure 2, un substrat de fabrication obtenu à la fin de la mise en oeuvre d'un exemple d'étape de préformation du substrat ;
- figure 3, une vue de côté du substrat de la figure 2, et
- figure 4, une vue de côté du substrat tel qu'obtenu après application d'une deuxième étape de moulage par compression d'une face de référence sur le substrat de la figure 2.

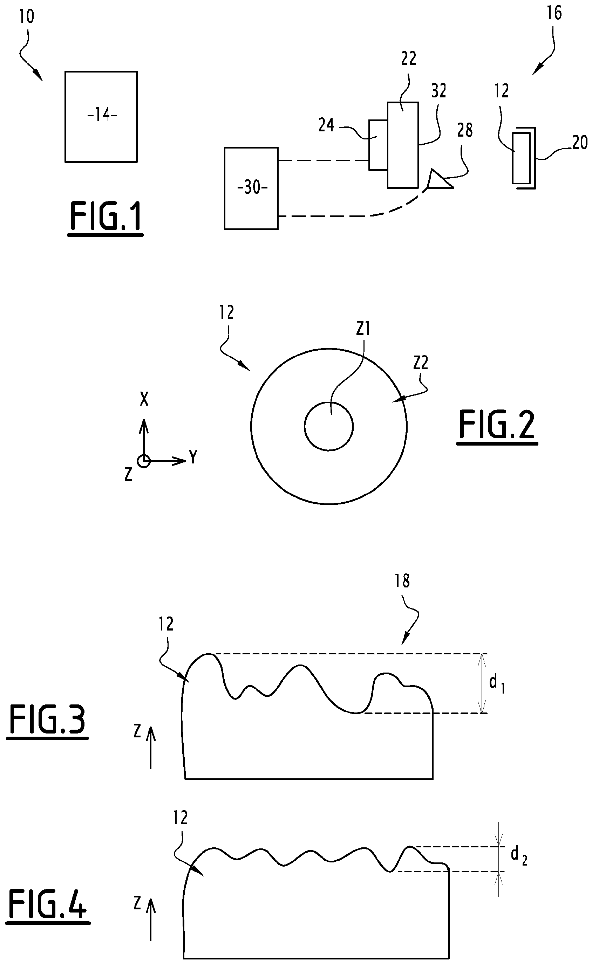

Un appareil de fabrication d'un substrat de composant opto-électronique 10 est représenté schématiquement sur la figure 1.

Dans ce qui suit, l'appareil de fabrication d'un substrat de composant opto-électronique 10 est plus simplement dénommé appareil de fabrication 10.

L'appareil de fabrication 10 est destiné à fabriquer un substrat 12.

Un substrat est un support servant de base à d'autres couches.

En l'espèce, l'empilement de couches est destiné à former un composant opto-électronique.

Un composant opto-électronique est un composant relevant de l'opto-électronique qui est à la fois une branche de l'électronique et de la photonique. Plus précisément, un composant opto-électronique est un composant qui émet ou interagit avec la lumière. A titre d'exemple, on peut citer les capteurs solaires ou les diodes électroluminescentes.

En l'espèce, l'appareil de fabrication 10 est, de préférence, destiné à fabriquer des substrats pour composants opto-électroniques structurés en couches minces.

L'appareil de fabrication 10 comporte une unité de préformation 14 et une unité de moulage par compression 16.

L'unité de préformation 14 est propre à mettre en oeuvre une étape de préformation du substrat 12.

L'unité de préformation 14 est, par exemple, une imprimante tri-dimensionnelle permettant de former le substrat 12 par addition de matière.

Un exemple de substrat 12 obtenu à l'issue de l'étape de préformation est représenté aux figures 2 et 3.

Le substrat 12 formé par l'unité de préformation 14 présente une face 18. Il est à noter qu'à ce stade, le substrat 12 est également désigné sous l'appellation « le préformé ».

La face 18 est la face destinée à accueillir un empilement de couches destiné à former le composant opto-électronique.

De ce fait, la face 18 est dénommée face de support 18 dans ce qui suit.

La face de support 18 étant planaire, il est défini une direction d'empilement Z correspondant à la direction perpendiculaire à la face de support 18. Il est également défini une première direction transversale représentée par un axe X sur la figure 2 et une deuxième direction transversale perpendiculaire à la direction d'empilement Z et à la première direction transversale X. La deuxième direction transversale est représentée par un axe Y sur la figure 2.

En variante, la face 18 du substrat 12 peut être non plane, notamment concave ou convexe.

La face de support 18 présente une première rugosité de surface notée R₁.

De manière générale, la rugosité de surface R est une caractérisation de l'état d'une surface. La rugosité caractérise en effet les défauts géométriques d'une surface.

La rugosité de surface R est, par exemple, mesurée par un profilomètre.

Dans le cas proposé, la première rugosité de surface R₁ est la rugosité maximale de la face de support 18, c'est-à-dire la distance entre le point le plus haut de la face de support 18 et le point le plus bas de la face de support 18, la distance étant mesurée le long de la direction d'empilement Z. La distance correspondante est une première distance d₁ est représentée sur la figure 3.

Selon une variante, la première rugosité de surface R₁ est la rugosité moyenne de la face de support, la rugosité moyenne étant la moyenne arithmétique des hauteurs en chaque point de la face de support.

Dans l'exemple présenté, la première rugosité de surface R₁ de la face de support 18 est supérieure ou égale à 50 nanomètres (nm).

Par exemple, la première rugosité de surface R₁ est supérieure à quelques microns.

De ce fait, l'étape de préformation que l'unité de préformation 14 est propre à mettre en oeuvre peut être qualifiée de grossière du fait qu'elle permet d'obtenir un substrat 12 présentant une face de support 18 impropre à être utilisé pour former un composant opto-électronique.

Selon l'exemple décrit, le substrat 12 présente une épaisseur le long de la direction d'empilement Z de 2,5 millimètres (mm) et la face de support présente des dimensions dans le plan défini par les directions transversales X et Y comprises entre 1 centimètre (cm) et 10 cm.

D'autres dimensions selon les directions transversales X et Y et selon la direction d'empilement Z sont bien entendu envisageables, l'appareil de fabrication 10 étant compatible avec de nombreuses dimensions de substrat 12.

La face de support 18 présente un motif avec une zone en un premier matériau M1 et une zone en un deuxième matériau M2.

Selon l'exemple de la figure 2, la zone en un deuxième matériau M2 entoure entièrement la zone en un premier matériau M1.

Par ailleurs, le substrat 12 présente une forme ronde.

Toutefois, d'autres formes sont possibles telles des formes en carré ou en hexagone.

En outre, il est à noter que, dans l'exemple illustré à la figure 2, le motif est un donut.

D'autres motifs sont envisageables.

En particulier, le motif consiste en un ensemble de zones de premier matériau M1 dispersées suivant un schéma précis au milieu d'un support en deuxième matériau M2. Les zones en premier matériau M1 sont agencées spatialement pour assurer une bonne homogénéité de la densité de courant électrique sur l'ensemble de la surface du substrat 12.

Le premier matériau M1 est un matériau conducteur électrique.

Le premier matériau M1 est un matériau thermoplastique.

Le premier matériau M1 est, par exemple, du PLA. PLA se rapporte au terme anglais de PolyLactic Acid qui signifie acide polylactique. L'acide polylactique est un polymère entièrement dégradable qui est souvent utilisé pour réaliser des produits du commerce, notamment dans l'industrie alimentaire.

En variante, le premier matériau M1 est de l'Acrylonitrile Butadiène Styrène, aussi nommée sous l'acronyme ABS. Plus généralement, le premier matériau M1 selon cette variante est un polymère styrénique.

Selon une autre variante, le premier matériau M1 est un matériau thermodurcissable comme, par exemple, une résine époxy.

Il est à noter que, dans un tel cas, les étapes de préformation et de moulage par compression sont mises en oeuvre simultanément.

De préférence, le premier matériau M1 est transparent si cela est favorable pour l'application envisagée pour le substrat 12.

Le deuxième matériau M2 est également un matériau thermoplastique.

Le deuxième matériau M2, au contraire du premier matériau M1, est un isolant électrique.

Les mêmes exemples que pour le cas précédent peuvent s'appliquer au deuxième matériau M2, comme notamment le cas du PLA ou de l'ABS.

De préférence, le premier matériau M1 et le deuxième matériau M2 sont identiques pour faciliter la fabrication du substrat à l'étape de préformation. Cela est aussi avantageux pour l'étape de moulage par compression décrite dans ce qui suit.

Par « matériaux identiques » dans ce contexte, il est entendu que le premier matériau M1 et le deuxième matériau M2 sont formés à partir du même matériau et diffèrent uniquement par la présence d'éléments rendant l'un conducteur ou l'autre isolant. Par exemple, de l'argent est introduit dans un matériau isolant pour obtenir le premier matériau M1, le matériau isolant sans argent étant le deuxième matériau M2. D'autres éléments peuvent être envisagés comme des structures à base de carbone telles du graphite, des fullerènes, des nanotubes de carbone et du graphène.

Lorsque le premier matériau M1 et le deuxième matériau M2 sont différents, comme il convient d'éviter l'apparition de zones de démarcation entre les deux zones lors de l'étape de moulage par compression, les matériaux M1 et M2 présentent de préférence des comportements similaires avec la température, notamment en termes de viscosité.

L'unité de moulage par compression 16, simplement dénommée unité de moulage 16 dans la suite, comporte un support 20, un élément de référence 22, un applicateur de pression 24, un organe de chauffage 28 et un contrôleur 30.

L'unité de moulage 16 est propre à mettre en oeuvre une étape de pressage à chaud du substrat 12 obtenu à l'issue de l'étape de préformation que l'unité de préformation 14 est propre à mettre en oeuvre.

Le moulage par compression est aussi connu sous le terme de pressage à chaud.

Le support 20 permet de maintenir le substrat 12 en position.

L'élément de référence 22 est destiné à être appliqué sur le substrat 12.

Dans le cas de la figure 1, l'élément de référence 22 se présente sous la forme d'une entretoise.

L'élément de référence 22 comporte une face d'application 32. La face d'application 32 est la surface entrant en contact avec le substrat 12 lorsque l'élément de référence 22 est appliqué sur le substrat 12.

La face d'application 32 présente une rugosité de surface de référence notée R_{REF}.

Dans ce cas, la rugosité de surface de référence R_{REF} est inférieure à 50 nm.

De préférence, la rugosité de surface de référence R_{REF} est inférieure à 20 nm.

Comme la rugosité de surface de référence R_{REF} est la rugosité de surface souhaitée pour le substrat 12, le qualificatif de référence est utilisé pour qualifier l'élément.

L'élément de référence 22 est, par exemple, en wafer de silicium.

En variante, l'élément de référence 22 est un wafer de verre.

Plus généralement, l'élément de référence 22 est en matériau dur dont la surface aurait été préparée pour avoir une rugosité de surface souhaitée inférieure à 20 nm par polissage par exemple.

L'applicateur de pression 24 est propre à appliquer une pression sur l'élément de référence 22 pour que le substrat 12 soit pressé entre l'élément de référence 22 d'une part et une partie du support 20.

L'ensemble du support 20 et de l'applicateur de pression 24 forme un moule.

Le terme de « presse » désigne parfois un tel moule, notamment lorsque la technique est appelée pressage à chaud.

L'organe de chauffage 28 est propre à appliquer des variations de températures à l'élément de référence 22 et au support 20, ce profil de températures dépendra essentiellement du ou des matériaux utilisés pour le substrat 12.

Le contrôleur 30 est propre à contrôler au moins certains éléments de l'unité de moulage 16, parmi lesquels l'organe de chauffage 28 et l'applicateur de pression 24.

Le fonctionnement de l'appareil de fabrication 10 est maintenant décrit en référence à un exemple de mise en oeuvre d'un procédé de fabrication du substrat de composant opto-électronique.

Le procédé de fabrication comporte une étape de préformation et une étape de moulage par compression.

Lors de l'étape de préformation, il est formé le substrat 12 tel que représenté sur les figures 2 et 3.

Selon l'exemple proposé, l'étape de préformation est mise en oeuvre par une impression tridimensionnelle.

L'impression tridimensionnelle désigne des procédés de fabrication de pièces en volume par ajout ou agglomération de matière. De manière usuelle, l'impression tridimensionnelle est souvent désignée sous le terme fabrication additive. La fabrication additive est définie comme un procédé de mise en forme d'une pièce par ajout de matière, par empilement de couches successives par opposition au procédé retirant de la matière tel que l'usinage.

En l'espèce, il est possible d'utiliser de la fusion sélective par laser, du frittage sélectif par laser ou du dépôt par fil fondu.

De préférence, il sera choisi la technique la moins difficile à mettre en oeuvre en fonction du matériau utilisé pour le substrat 12.

Selon un autre mode de réalisation, une technique de multi-injection correspondant à l'étape de préformation et de moulage par compression est mise en oeuvre.

L'injection multi-matière consiste à injecter dans un même outillage et dans un même moule plusieurs matières thermoplastiques ou thermodurcissables différentes et compatibles. Une même pièce pourra donc être constituée de plusieurs matières.

Lors d'une technique d'injection multi-matière, la mise en forme définitive des matériaux M1 et M2 a lieu simultanément.

A l'issue de l'étape de préformation, dans l'exemple décrit, il est ainsi obtenu un substrat 12 pour composant opto-électronique comportant un motif avec une ou plusieurs zones réalisées dans le premier matériau M1 et une zone réalisée dans le deuxième matériau M2. En outre, ce substrat 12 présente une face de support 18 avec une première rugosité de surface R₁ strictement supérieure à 50 nm.

Lors de l'étape de moulage, le substrat 12 est chauffé à une température supérieure aux températures de fusion du premier matériau M1 et du deuxième matériau M2 à l'aide de l'organe de chauffage 28.

Simultanément, l'applicateur de pression 24 appuie sur l'élément de référence 22 de sorte que la face d'application 32 soit pressée contre la face de support 18 du substrat 12 avec une pression prédéfinie. Ainsi, la face de support 18 est compressée avec la face d'application 32.

La pression appliquée dépend notamment de la température à laquelle le substrat 12 est chauffé ainsi que des matériaux M1 et M2 considérés.

Selon l'exemple décrit, la pression prédéfinie est comprise entre 1 bar et 5 bars.

La pression prédéfinie est appliquée pendant une durée inférieure à une dizaine de minutes.

Lors de l'étape de moulage, la face de support 18 du substrat 12 étant chauffée au-dessus de leur température de fusion, le premier matériau M1 et le deuxième matériau M2 présentent une viscosité assez faible pour être fortement déformables et sont donc très conformables. L'application de la face d'application 32 sur la face de support 18 du substrat 12 entraîne alors un transfert de la rugosité de surface de face d'application 32 (la rugosité de surface de référence R_{REF}) sur la face de support 18 du substrat 12. En l'espèce, la face d'application 32 de l'élément de référence 20 présente une rugosité de surface inférieure ou égale à cinquante nanomètres, le substrat 12 obtenu présente une deuxième rugosité de surface R₂ inférieure ou égale à 50 nm.

Dans le cas où la face d'application 32 de l'élément de référence 20 présente une rugosité de surface inférieure ou égale à 20 nm, le substrat 12 obtenu présente une deuxième rugosité de surface R₂ inférieure ou égale à 20 nm.

Comme précédemment, la deuxième rugosité de surface R₂ est la rugosité maximale de la face de support 18, c'est-à-dire la distance entre le point le plus haut de la face de support 18 et le point le plus bas de la face de support 18, la distance étant mesurée le long de la direction d'empilement Z. La distance correspondante est une deuxième distance d₂ est représentée sur la figure 4. La deuxième distance d₂ est très inférieure à la première distance d₁.

Ainsi, il a été obtenu avec un procédé de fabrication peu onéreux et facilement industrialisable un substrat 12 présentant des zones électriquement conductrices et de bonnes propriétés de surface.

En effet, le substrat 12 permet l'établissement de deux contacts électriques du fait que les deux zones Z1 et Z2 présentent des propriétés électriques différentes et sont accessibles au niveau des deux faces du substrat 12. Un tel substrat 12 est un substrat à contact électrique traversant.

En outre, le moulage par compression permet d'obtenir une surface de très bonne qualité en termes de rugosité de surface.

Il est à noter que ce choix d'étape résulte d'un véritable travail de recherche de la part des inventeurs.

Notamment, une pluralité de techniques a été testée, parmi lesquelles l'emploi de moulage, l'emploi de découpe laser ou l'emploi d'une micro-fraiseuse. Aucune combinaison testée par la demanderesse n'a permis à ce jour d'obtenir des résultats satisfaisants.

Le procédé de fabrication présente, en outre, l'avantage de permettre d'utiliser l'élément de référence 22 une pluralité de fois.

Du fait de ces propriétés, un tel substrat 12 est compatible avec la réalisation de tout composant opto-électronique.

Notamment, le fait que le substrat 12 soit un substrat à contact électrique traversant implique que la surface du substrat est utilisable à 100% puisqu'aucune zone n'a besoin d'être réservée aux lignes de contacts électriques.

Ainsi, le substrat 12 peut avantageusement être utilisé pour fabriquer une diode électroluminescente organique ou une cellule photovoltaïque organique.

Pour illustrer une telle possibilité, il est décrit un procédé de fabrication d'une diode électroluminescente organique depuis le départ.

Le procédé de fabrication d'une diode électroluminescente organique comporte d'abord les mêmes étapes que le procédé de fabrication du substrat précédemment décrit pour obtenir le substrat 12.

Une fois le substrat 12 réalisé, les différentes couches constituant la diode électroluminescente organique sont déposées.

Il convient alors de distinguer deux cas, à savoir une première configuration d'émission par le bas (à travers le substrat) et une deuxième configuration d'émission par le haut. La première configuration est aussi appelée sous la dénomination anglaise de « back-emitting » tandis que la deuxième configuration est appelée sous le terme anglais de « top-emitting ».

Pour le cas de la première configuration, l'anode est déposée sur le substrat 12 grâce à une technique de pulvérisation cathodique.

L'anode est, par exemple, réalisée en oxyde d'indium-étain aussi dénommée ITO.

En variante, l'anode est réalisée en matériau AZO, correspondant à une couche d'oxyde de zinc (ZnO) dopé Aluminium.

Puis, différentes couches de matériaux semi-conducteurs organiques sont déposées. Les différentes couches organiques déposées qui constitueront l'architecture de la diode électroluminescente organique peuvent varier en nombre et dans leur fonction, par exemple, on pourra utiliser une structure bi-couches avec du N,N'-Di(1-naphthyl)-N,N'-diphenyl-(1,1'-biphenyl)-4,4'-diamine aussi désignée par la formule NPB comme transporteur de trous et utiliser du tris(8-hydroxyquinoline)aluminium(III), généralement abrégé en Alq3, comme matériaux pour la couche à double fonction d'émission de lumière et de transporteur d'électrons.

Selon un exemple, les couches de matériaux semi-conducteurs organiques sont déposées par une technique en voie sèche.

A titre d'exemple, l'évaporation thermique ou la pulvérisation cathodique permettent un tel dépôt.

Dans le cas de l'évaporation thermique, il est utilisé un système d'évaporation équipé d'une chambre dans laquelle sont placées une source et la cible de dépôt ainsi qu'une pompe pour faire le vide et une source d'énergie permettant l'évaporation. Dans le cas d'une évaporation thermique, le matériel à déposer est placé dans un creuset qui est chauffé par un courant électrique.

La pulvérisation cathodique, aussi appelée selon le terme anglais de « sputtering », est une technique de dépôt de couche mince. Cette technique permet le dépôt de matériaux issue d'une source solide aussi appelée cible qui est soumise à un plasma. Au sein de ce plasma, un bombardement ionique va arracher des atomes de la cible et donc du matériau choisi qui va se déposer sur un substrat défini.

Selon encore une variante, le dépôt des couches de matériaux semi-conducteurs organiques est mis en oeuvre selon une technique en voie humide.

L'enduction centrifuge est un exemple de technique en voie humide.

L'enduction centrifuge ou l'enduction par centrifugation est plus connue sous sa dénomination anglaise de « spin coating ». L'enduction centrifuge consiste en une technique de déposition de couches minces et uniformes sur la surface plane d'un substrat.

Enfin, la cathode est déposée pour obtenir la diode électroluminescente organique selon la première configuration appelée « back-emitting ».

A l'aide d'une source d'évaporation haute température, un dépôt d'aluminium est effectué sur la totalité de la surface représentée par le dépôt des couches organiques ainsi que sur le côté du substrat pour pouvoir être en contact électrique.

En variante, des couches de calcium, de magnésium ou d'argent sont déposées.

Par contraste, dans le cas de la deuxième configuration, le procédé de fabrication est sensiblement le même à l'exception du fait que l'ordre des dépôts est inversé, la cathode étant située en dessous des zones d'émission organiques et donc directement déposée sur la surface du substrat 12.

Il est ainsi obtenu une diode électroluminescente organique dont le fonctionnement est maintenant expliqué.

En fonctionnement, une telle diode électroluminescente fonctionne de la manière suivante. Lorsqu'une différence de potentiel est appliquée entre l'anode et la cathode, un champ électrique se forme ce qui a pour conséquence de faire circuler un courant à travers les différentes couches de matériaux semi-conducteurs organiques constituant la diode. Ainsi la cathode fournit des charges négatives, c'est-à-dire des électrons tandis que l'anode apporte des trous, c'est-à-dire des charges positives. Les deux porteurs de charges se déplacent par saut de molécules en molécules au travers des couches de matériaux organiques jusqu'à se rencontrer dans une zone de recombinaison.

Lorsque cette rencontre a lieu, un exciton se forme puis se désexcite. C'est la désexcitation de l'exciton qui créé le rayonnement.

Ce mécanisme de fluorescence est le mécanisme de base de l'émission de lumière dans les diodes électroluminescentes organiques. Il est en outre à noter que la longueur d'ondes de la lumière émise par les diodes électroluminescentes organiques est proportionnelle à la différence d'énergie entre les niveaux d'énergie impliquée dans la désexcitation de l'exciton.

De manière connue, le procédé de fabrication de la diode électroluminescente organique peut également comporter d'autres étapes comme une étape d'encapsulation.

En conclusion, il est à noter que le substrat 12 ainsi obtenu permet de manière générale de déposer des composants électroniques organiques en couches de quelques dizaines de nanomètres. Un tel substrat 12 permet d'avoir une utilisation à 100% de sa surface.

Par exemple, dans le cas illustré du dépôt d'une diode électroluminescente organique, il est possible d'avoir une surface qui soit entièrement émettrice de lumière. Il a ainsi obtenu une surface d'éclairage qui pourrait s'apparenter à un macropixel dont une face avant est une surface émettrice. Un tel macropixel peut être qualifié de macropixel électroluminescent organique.

Par assemblage, le macropixel permettra de créer des ensembles de macropixels, les ensembles correspondant à des sources d'éclairage ou des panneaux d'affichage de grandes dimensions sans surcoût de production qui sont inhérents à l'augmentation de la taille de la zone d'éclairage dans les technologies organiques actuelles.

Par grande dimension, dans ce contexte, il est entendu qu'au moins une des dimensions du panneau est supérieure ou égale à trente centimètres.

Un tel type d'ensemble est avantageusement utilisé dans le milieu du transport pour les véhicules mobiles comme les trains ou les avions. Un tel ensemble est, par exemple, un dispositif d'éclairage intérieur d'un avion ou un dispositif d'affichage sur l'extérieur de l'avion.

L'invention concerne toute combinaison techniquement possible des modes de réalisation précédemment décrits.

## Revendications

1. Procédé de fabrication d'un substrat (12) de composant opto-électronique comportant un empilement de couches, le procédé comportant une étape de :
- préformation d'un substrat (12) comportant une face (18) présentant un motif avec au moins une zone en un premier matériau (M1) et une zone en un deuxième matériau (M2), les deux matériaux (M1, M2) étant des matériaux thermodurcissables ou thermoplastiques, le premier matériau (M1) étant un matériau conducteur électrique et le deuxième matériau (M2) étant un matériau isolant électrique, et
- moulage par compression de la face (18) du substrat (12) avec une face (32) d'un élément de référence (22) présentant une rugosité de surface inférieure ou égale à 50 nanomètres.

2. Procédé de fabrication selon la revendication 1, dans lequel la face de l'élément de référence (22) présente une rugosité de surface inférieure ou égale à 20 nanomètres.

3. Procédé de fabrication selon la revendication 1 ou 2, dans lequel le premier matériau (M1) est identique au deuxième matériau (M2).

4. Procédé de fabrication selon l'une quelconque des revendications 1 à 3, dans lequel, lors de l'étape de préformation, il est utilisé une technique de fabrication additive.

5. Procédé de fabrication d'un composant opto-électronique, notamment une diode électroluminescente organique ou une cellule photovoltaïque organique, comportant les étapes du procédé de fabrication d'un substrat (12) selon l'une quelconque des revendications 1 à 4.

6. Substrat (12) obtenu par le procédé de fabrication selon l'une quelconque des revendications 1 à 5.

7. Composant opto-électronique, notamment une diode électroluminescente organique ou une cellule photovoltaïque organique, comportant un substrat (12) selon la revendication 6.

8. Ensemble, notamment panneau d'affichage ou source d'éclairage, comportant une pluralité de composants opto-électroniques selon la revendication 7.

9. Appareil de fabrication (10) d'un substrat (12) de composant opto-électronique comportant un empilement de couches, l'appareil de fabrication (10) comportant :
- une unité de préformation (14) d'un substrat (12) comportant une face (18) présentant un motif avec au moins une zone en un premier matériau (M1) et une zone en un deuxième matériau (M2), les deux matériaux (M1, M2) étant des matériaux thermodurcissables ou thermoplastiques, le premier matériau (M1) étant un matériau conducteur électrique et le deuxième matériau (M2) étant un matériau isolant électrique, et
- une unité de moulage par compression (16) de la face (18) du substrat (12) avec une face (32) d'un élément de référence (22) présentant une rugosité de surface inférieure ou égale à 50 nanomètres.

## Patentansprüche

1. Herstellungsverfahren eines Substrats (12) einer optoelektronischen Komponente, umfassend einen Stapel von Schichten, das Verfahren umfassend einen folgenden Schritt:
- Vorformen eines Substrats (12), umfassend eine Seite (18), die ein Muster mit mindestens einem Bereich aus einem ersten Material (M1) und einem Bereich aus einem zweiten Material (M2) aufweist, wobei beide Materialien (M1, M2) wärmehärtende oder thermoplastische Materialien sind, das erste Material (M1) ein elektrisch leitendes Material ist und das zweite Material (M2) ein elektrisch isolierendes Material ist, und
- Formpressen der Seite (18) des Substrats (12) mit einer Seite (32) eines Referenzelements (22), das eine Oberflächenrauheit kleiner als oder gleich wie 50 Nanometer aufweist.

2. Herstellungsverfahren nach Anspruch 1, wobei die Seite des Referenzelements (22) eine Oberflächenrauheit kleiner als oder gleich wie 20 Nanometer aufweist.

3. Herstellungsverfahren nach Anspruch 1 oder 2, wobei das erste Material (M1) mit dem zweiten Material (M2) identisch ist.

4. Herstellungsverfahren nach einem der Ansprüche 1 bis 3, wobei bei dem Vorformungsschritt eine additive Fertigungstechnik verwendet wird.

5. Herstellungsverfahren einer optoelektronischen Komponente, insbesondere einer organischen lichtemittierenden Diode oder einer organischen photovoltaischen Zelle, umfassend die Schritte des Herstellungsverfahrens eines Substrats (12) nach einem der Ansprüche 1 bis 4.

6. Substrat (12), das durch das Herstellungsverfahren nach einem der Ansprüche 1 bis 5 erlangt wird.

7. Optoelektronische Komponente, insbesondere eine organische lichtemittierende Diode oder eine organische photovoltaische Zelle, umfassend ein Substrat (12) nach Anspruch 6.

8. Komponente, insbesondere Anzeigetafel oder Beleuchtungsquelle, umfassend eine Vielzahl von optoelektronischen Komponenten nach Anspruch 7.

9. Vorrichtung zur Herstellung (10) eines Substrats (12) für eine optoelektronische Komponente, umfassend einen Stapel von Schichten, die Vorrichtung zur Herstellung (10) umfassend:
- eine Vorformungseinheit (14) eines Substrats (12), umfassend eine Seite (18), die ein Muster mit mindestens einem Bereich aus einem ersten Material (M1) und einem Bereich aus einem zweiten Material (M2) aufweist, wobei beide Materialien (M1, M2) wärmehärtende oder thermoplastische Materialien sind, das erste Material (M1) ein elektrisch leitendes Material ist und das zweite Material (M2) ein elektrisch isolierendes Material ist, und
- eine Formpresseinheit (16) der Seite (18) des Substrats (12) mit einer Seite (32) eines Referenzelements (22), das eine Oberflächenrauheit kleiner als oder gleich wie 50 Nanometer aufweist.

## Claims

1. A method for manufacturing a substrate (12) of an optoelectronic component comprising a stack of layers, the method comprising a step of :
- preforming a substrate (12) comprising a face (18) having a pattern with at least one zone made of a first material (M1) and a zone made of a second material (M2), the two materials (M1, M2) being thermosetting or thermoplastic materials, the first material (M1) being an electrically conductive material and the second material (M2) being an electrically insulating material, and
- molding by compression the face (18) of the substrate (12) with a face (32) of a reference element (22) presenting a surface roughness less than or equal to 50 nanometers.

2. The manufacturing method according to claim 1, wherein the face of the reference element (22) has a surface roughness of less than or equal to 20 nanometers.

3. The manufacturing method according to claim 1 or 2, wherein the first material (M1) is identical to the second material (M2).

4. The manufacturing method according to any one of claims 1 to 3, wherein an additive manufacturing technique is used in the preforming step.

5. The method for manufacturing an optoelectronic component, in particular an organic light-emitting diode or an organic photovoltaic cell, comprising the steps of the method for manufacturing a substrate (12) according to any one of claims 1 to 4.

6. The substrate (12) obtained by the manufacturing method according to any one of claims 1 to 5.

7. The optoelectronic component, in particular an organic light-emitting diode or an organic photovoltaic cell, comprising a substrate (12) according to claim 6.

8. An assembly, in particular a display panel or lighting source, comprising a plurality of optoelectronic components according to claim 7.

9. The manufacturing apparatus (10) for manufacturing a substrate (12) of an optoelectronic component comprising a stack of layers, the manufacturing apparatus (10) comprising :
- a unit (14) for preforming a substrate (12) comprising a face (18) presenting a pattern with at least one zone made of a first material (M1) and a zone made of a second material (M2), the two materials (M1, M2) being thermosetting or thermoplastic materials, the first material (M1) being an electrically conductive material and the second material (M2) being an electrically insulating material, and
- a molding by compression unit (16) of the face (18) of the substrate (12) with a face (32) of a reference element (22) presenting a surface roughness less than or equal to 50 nanometers.
